# EUROPEAN PATENT APPLICATION

(11) **EP 4 679 958 A1**
(43) Date of publication of application: **14.01.2026**
(21) Application number: 25188252.8
(22) Date of filing: 08.07.2025
(51) Int. Cl.: H05K 7/20

(54) **POWER CONVERTER**

(30) Priority: 09.07.2024 CN 202421620460 U
(71) Applicant: HUAWEI DIGITAL POWER TECHNOLOGIES CO., LTD., Shenzhen Guangdong 518043 (CN)
(72) Inventor: CHEN, Dong, Shenzhen, 518043 (CN); TANG, Yunyu, Shenzhen, 518043 (CN); SHI, Lei, Shenzhen, 518043 (CN)
(74) Representative: Gill Jennings & Every LLP

(57) **Abstract**

Embodiments of this application provide a power converter, and relate to the field of energy technologies. The power converter is configured to convert a direct current from a photovoltaic module or an energy storage battery into an alternating current. The power converter includes a housing, one or more power modules, and a heat sink. The housing is configured to accommodate the power module. The heat sink includes a substrate, one or more heat pipes, and a plurality of heat dissipation fins. One surface of the substrate is attached to the power module. The heat pipe is further embedded in the surface of the substrate. The plurality of heat dissipation fins are disposed on the other surface of the substrate. The surface of the substrate is disposed opposite to the other surface of the substrate in a first direction. An orthographic projection of the heat pipe on the surface that is of the substrate and that is attached to the power module is located on an outer side of an orthographic projection of the power module on the surface. A thermal conductivity of the substrate is less than a thermal conductivity of the heat pipe. The heat sink can be better used, to facilitate heat dissipation of the power module.

## Description

### TECHNICAL FIELD

This application relates to the field of energy technologies, and in particular, to a power converter.

### BACKGROUND

With development of the energy field, electrical devices such as an inverter are widely used in various scenarios. These electrical devices usually include a power module (or a power device). The power module generates heat during operating, and a heat sink needs to be used to perform heat dissipation for the power module, to prevent the power module from being damaged due to overtemperature.

In the related technology, the power module is in direct contact with the heat sink, heat on the power module is transferred to the heat sink, and heat is exchanged with air by using the heat sink, to implement heat dissipation. However, when a solution of the related technology is used, a large quantity of areas on the heat sink cannot be effectively used, causing a functional waste of the large quantity of areas on the heat sink and affecting heat dissipation of the power module.

### UTILITY MODEL CONTENT

This application provides a power converter, to better use a heat sink to facilitate heat dissipation of a power module.

To achieve the foregoing objective, this application uses the following technical solutions.

This application provides a power converter. The power converter is configured to convert a direct current from a photovoltaic module or an energy storage battery into an alternating current. The power converter includes a housing, one or more power modules, and a heat sink. The housing is configured to accommodate the power module. The heat sink includes a substrate, one or more heat pipes, and a plurality of heat dissipation fins. One surface of the substrate is attached to the power module. The heat pipe is further embedded in the surface of the substrate. The plurality of heat dissipation fins are disposed on the other surface of the substrate. The surface of the substrate is disposed opposite to the other surface of the substrate in a first direction. An orthographic projection of the heat pipe on the surface that is of the substrate and that is attached to the power module is located on an outer side of an orthographic projection of the power module on the surface. A thermal conductivity of the substrate is less than a thermal conductivity of the heat pipe.

When the power converter runs, the direct current from the photovoltaic module or the energy storage battery may be converted into the alternating current. The power module generates heat, and heat on the power module is transferred to the substrate, and then is transferred from the substrate to the heat dissipation fins for heat exchange with air. In addition, the heat pipe located on the substrate has a stronger thermal conductive capability, and heat on the substrate may be transferred to another location of the substrate through the heat pipe. For example, the heat pipe may transfer the heat to an area that is of the substrate and that is located on an outer periphery or an outer side of the power module, and heat is exchanged with air by using the heat dissipation fins that are of the substrate and that are in the area, so that more areas on the heat sink are fully used for heat dissipation, to implement efficient heat dissipation for the power module. In addition, the power module and the heat pipe are disposed in a staggered manner in the first direction, and the power module and the heat pipe do not overlap. In other words, the power module is not in contact with the heat pipe. This reduces impact of the heat pipe and the substrate on mounting of the power module caused by different thermal expansion coefficients.

In an optional implementation, the power converter further includes a plurality of direct-current terminals. The plurality of direct-current terminals are configured to connect to the photovoltaic module or the energy storage battery. The plurality of direct-current terminals are fastened and partially exposed from the housing. The direct-current terminals and the power module are arranged in a second direction. The second direction is perpendicular to a first direction. The heat pipe includes a heated portion and a heat transfer portion. The heated portion does not exceed an edge of the power module in a third direction. The heat transfer portion exceeds the edge of the power module in the third direction. The third direction is perpendicular to the first direction and the second direction. The power module is located between the heated portion and the direct-current terminals in the second direction.

After the power converter is mounted, the direct-current terminals may be located at the bottom of the housing. During natural heat dissipation, hot air rises, heat of the power module is concentrated in an area above the power module, and the heated portion is disposed in the area. That is, a large amount of heat of the power module is gathered to the heated portion, and then is transferred from the heated portion to the heat transfer portion. Because the heat transfer portion protrudes from the edge of the power module, heat on the heat transfer portion may be transferred to an area that is of the substrate and that is located in an area around the power module, so that more areas on the heat sink are used, and heat dissipation effect is better.

In an optional implementation, the power converter further includes a fan. The fan and the power module are arranged in the second direction. The power module is located between an air outlet of the fan and the heated portion in the second direction.

After the power converter is mounted, the direct-current terminals may be located at the bottom of the housing. The fan may be located below the power module. In a running process of the power converter, the fan blows air toward the power module, and most heat on the power module is concentrated on one side that is of the power module and that is away from the fan. The heated portion is disposed in the area. Under an action of the fan, a large amount of heat of the power module is blown to the heated portion, and then is transferred from the heated portion to the heat transfer portion. Because the heat transfer portion protrudes from the edge of the power module, heat on the heat transfer portion may be transferred to a side area of the power module. In this way, more areas on the heat sink are used. Fan heat dissipation and natural heat dissipation are combined, and fan heat dissipation assists natural heat dissipation. This helps improve heat dissipation effect of the power module.

In an optional implementation, the power converter further includes a fan. The fan and the power module are arranged in a third direction. The third direction is perpendicular to the first direction. The power converter further includes a plurality of direct-current terminals. The plurality of direct-current terminals are configured to connect to the photovoltaic module or the energy storage battery. The direct-current terminals are fastened to the housing and exposed from the housing. The direct-current terminals and the power module are arranged in a second direction. The second direction is perpendicular to the first direction and the third direction. The heat pipe includes a heated portion and a heat transfer portion. The heated portion does not exceed an edge of the power module in the second direction. The heat transfer portion exceeds the edge of the power module in the second direction. The power module is located between an air outlet of the fan and the heated portion in the third direction.

After the power converter is mounted, the direct-current terminals may be located at the bottom of the housing. The fan may be located on a side of the power module. The fan blows air toward the power module, so that most heat on the power module is concentrated on one side that is of the power module and that is away from the fan. The heated portion is disposed in the area. A large amount of heat of the power module is blown to the heated portion by the fan, and then is transferred from the heated portion to the heat transfer portion. Because the heat transfer portion protrudes from the edge of the power module, heat on the heat transfer portion may be transferred to an area that is of the substrate and that is located around the power module, so that more areas on the heat sink are used, to improve heat dissipation effect of the power module.

In an optional implementation, an arrangement direction of the plurality of heat dissipation fins is perpendicular to an arrangement direction of the fan and the power module. An air duct is formed between two adjacent heat dissipation fins. The air duct extends in the arrangement direction of the fan and the power module. The air outlet of the fan faces one end that is of at least one air duct and that is close to the fan.

When the fan blows air toward the heat dissipation fins, the air flows through the heat dissipation fins through the air duct, so that air blown out from the fan flows in the arrangement direction of the fan and the power module. Because the heated portion is located on one side that is of the power module and that is away from the fan, heat is also transferred to the heated portion in a flow direction of the air. This helps the heated portion concentrate heat and then transfer the heat to the outside. In addition, an extension direction of the air duct is the same as an air direction. This also helps air flow in the air duct, reduces a possibility that the heat dissipation fins obstruct the air flow, and enables the fan to dissipate heat normally.

In an optional implementation, the heat transfer portion of the heat pipe bends toward the power module.

Because the heat transfer portion exceeds an edge of the heat pipe and bends toward the power module, heat on the heat pipe is conducted to a side of the power module, that is, heat is guided to an area that is difficult for heat on the substrate to reach. An area that is of the heat sink and that is located on the side of the power module is fully used, so that more areas on the heat sink can be used for heat dissipation, and utilization and heat dissipation effect of the heat sink are improved.

In an optional implementation, the heat transfer portion includes a first part and a second part. An arrangement direction of the first part and the second part is perpendicular to an arrangement direction of the heated portion and the power module. The first part and the second part respectively exceed edges of different sides of the power module in the arrangement direction of the first part and the second part.

According to the foregoing design manner, heat on the heat pipe is conducted to two sides of the power module, and the heat is guided to more areas of the substrate through the heat pipe, and areas that are of the heat sink and that are located on the two sides of the power module are fully used, so that used areas of the heat sink are further increased, to further improve the heat dissipation effect.

In an optional implementation, a plurality of power modules are disposed. The plurality of power modules include a direct-current voltage conversion module and an inverter module. The direct-current voltage conversion module is configured to perform voltage conversion on a direct current of the photovoltaic module or the energy storage battery. The inverter module is configured to convert a direct current output by the direct-current voltage conversion module into an alternating current. The inverter module, the heat pipe, and the direct-current voltage conversion module are sequentially arranged in the second direction. The direct-current voltage conversion module is located between the inverter module and the direct-current terminals in the second direction. In the second direction, a distance between the inverter module and the heat pipe that is located between the inverter module and the direct-current voltage conversion module is less than a distance between the direct-current voltage conversion module and the heat pipe that is located between the inverter module and the direct-current voltage conversion module.

When heat of the direct-current voltage conversion module is transferred in the second direction, heat can be transferred to the heated portion located between the direct-current voltage conversion module and the inverter module. Because the heat pipe between the inverter module and the direct-current voltage conversion module is closer to the inverter module, a part of heat of the inverter module is also transferred to the heated portion. The heat pipe may also dissipate heat for the inverter module while assisting the direct-current voltage conversion module in heat dissipation, so that heat of the inverter module with a high temperature can be better dissipated.

In an optional implementation, the heat transfer portion of the heat pipe located between the inverter module and the direct-current voltage conversion module bends toward the direct-current voltage conversion module.

Heat on the heat pipe can be conducted to a side of the direct-current voltage conversion module. An area that is of the heat sink and that is located on the side of the direct-current voltage conversion module is fully used, so that more areas on the heat sink can be used for heat dissipation. This improves utilization of the heat sink, and also helps improve heat dissipation effect of the direct-current voltage conversion module.

In an optional implementation, a groove is provided on the surface that is of the substrate and that is attached to the power module, the groove is located on an outer periphery of the power module, and the heat pipe is disposed in the groove.

In a manner of disposing the groove, the heat pipe is embedded in the substrate, and the groove is located on the outer periphery of the power module. In this way, the heat pipe in the groove is also located on the outer periphery of the power module, so that the power module and the heat pipe do not overlap in the first direction. In other words, the power module is not in contact with the heat pipe. This reduces impact of the heat pipe and the substrate on mounting of the power module caused by different thermal expansion coefficients.

### BRIEF DESCRIPTION OF DRAWINGS

FIG. 1 is a diagram of an overall structure of a power converter according to an embodiment of this application;
FIG. 2 is a diagram of a structure of a circuit board and a power module according to an embodiment of this application;
FIG. 3 is a diagram of an overall structure of a heat sink according to an embodiment of this application;
FIG. 4 is a sectional view of a power converter according to an embodiment of this application;
FIG. 5 is a diagram of a structure of a heat sink and a power module in the related technology of this application;
FIG. 6 is a diagram of another structure of a heat sink and a power module in the related technology of this application;
FIG. 7 is a diagram of a location relationship between a power module and a heat pipe according to an embodiment of this application;
FIG. 8 is a diagram of cooperation between a power module and a heat sink according to an embodiment of this application;
FIG. 9 is a diagram of another kind of cooperation between a power module and a heat sink according to an embodiment of this application;
FIG. 10 is a diagram of still another kind of cooperation between a power module and a heat sink according to an embodiment of this application;
FIG. 11 is a diagram of a structure of a direct-current terminal according to an embodiment of this application;
FIG. 12 is a diagram of a distance between a heat pipe and a direct-current terminal and a distance between a power module and a direct-current terminal according to an embodiment of this application;
FIG. 13 is a diagram of a structure of an inverter module and a direct-current voltage conversion module according to an embodiment of this application;
FIG. 14 is a diagram of a structure of a fan according to an embodiment of this application;
FIG. 15 is a diagram of a distance between a heat pipe and a fan and a distance between a power module and a fan according to an embodiment of this application;
FIG. 16 is a diagram of another structure of a fan according to an embodiment of this application;
FIG. 17 is a diagram of another distance between a heat pipe and a fan and another distance between a power module and a fan according to an embodiment of this application;
FIG. 18 is a diagram of another location relationship between a power module and a heat pipe according to an embodiment of this application; and
FIG. 19 is a diagram of still another location relationship between a power module and a heat pipe according to an embodiment of this application.

Reference numerals:
100: power converter; 1: housing; 11: opening; 2: heat sink; 21: substrate; 211: groove; 212: surface; 22: heat pipe; 22a: first heat pipe; 22b: second heat pipe; 22c: third heat pipe; 221: heated portion; 222: heat transfer portion; 2221: first part; 2222: second part; 23: heat dissipation fin; 231: air duct; 3: circuit board; 4: power module; 4a: first power module; 4b: second power module; 4c: third power module; 41: inverter module; 42: direct-current voltage conversion module; 5: direct-current terminal; 6: fan; 7: thermally conductive pad.

### DESCRIPTION OF EMBODIMENTS

The following describes technical solutions in embodiments of this application with reference to the accompanying drawings in embodiments of this application. It is clear that the described embodiments are merely a part rather than all of embodiments of this application.

Entity structures such as a component and an assembly in embodiments of this application are represented by using guide lines; hollow structures such as an opening, a hole, space, and a cavity are represented by using guide lines with hollow arrows; and a size and a direction are represented by using guide lines with solid arrows.

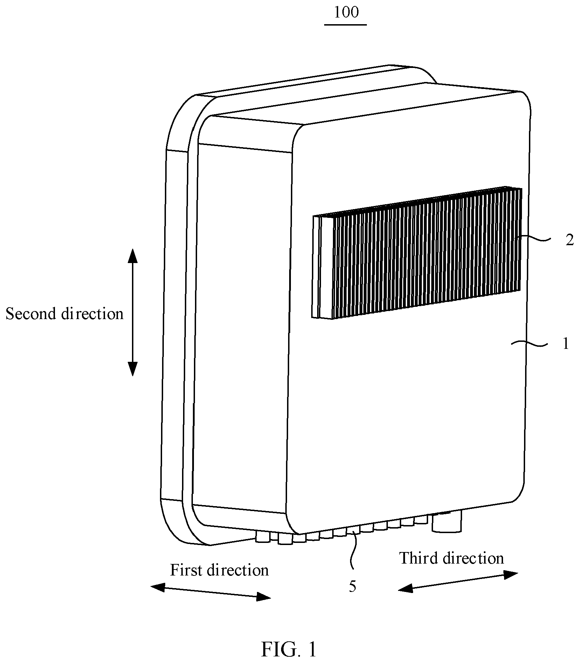

An embodiment of this application provides a power converter 100, for example, a photovoltaic inverter. The power converter 100 is configured to convert a direct current from a photovoltaic module into an alternating current. In another example, the power converter 100 may also be configured to convert a direct current from an energy storage battery (or an energy storage box) into an alternating current. FIG. 1 shows an example of a structure of a power converter 100. With reference to FIG. 1, the power converter 100 includes a housing 1 and a heat sink 2, where the heat sink 2 may be fastened outside the housing 1. In some other examples, a protection cover provided with a heat dissipation hole may be disposed outside the heat sink 2. In some other examples, the heat sink 2 may alternatively be disposed in the housing 1. In this example, the housing 1 is provided with a plurality of heat dissipation holes.

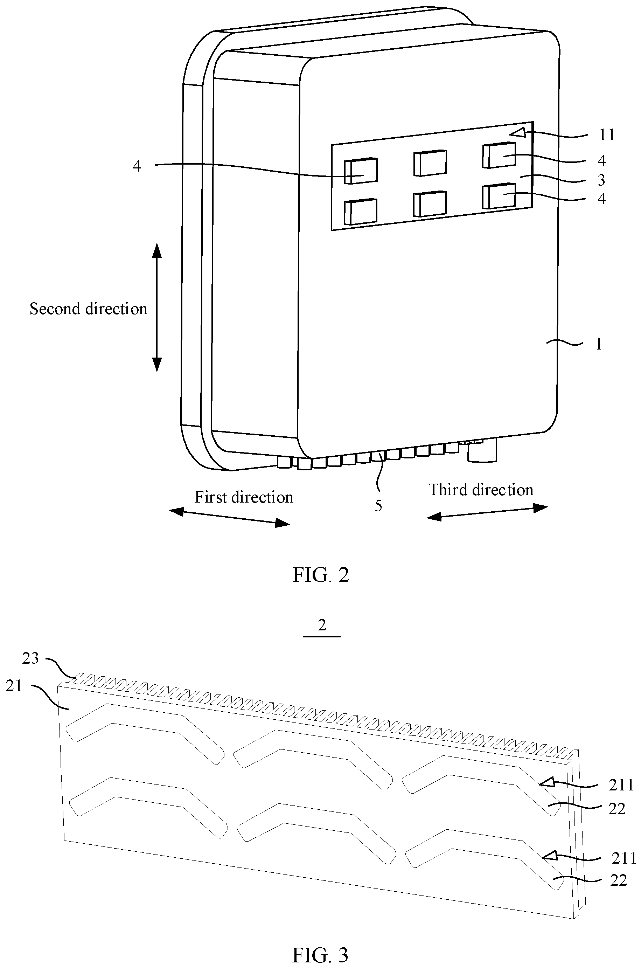

In addition, the power converter 100 further includes a circuit board 3 (printed circuit board, PCB) and one or more power modules 4 (or power devices). FIG. 2 shows an example of a structure of the power module 4. The power module 4 may be an inverter module 41 in which an inverter circuit is disposed, or the power module 4 may be a direct-current voltage conversion module 42 in which a boost circuit or a buck circuit is disposed, or the power module 4 may be another power device that generates severe heat and has a specific function. Refer to FIG. 2. A plurality of power modules 4 are disposed, and the plurality of power modules 4 are all disposed on the circuit board 3. The housing 1 is configured to accommodate the circuit board 3 and the plurality of power modules 4. In addition, the housing 1 is provided with an opening 11, and the plurality of power modules 4 are disposed at the opening 11, so that the heat sink 2 dissipates heat for the power modules 4.

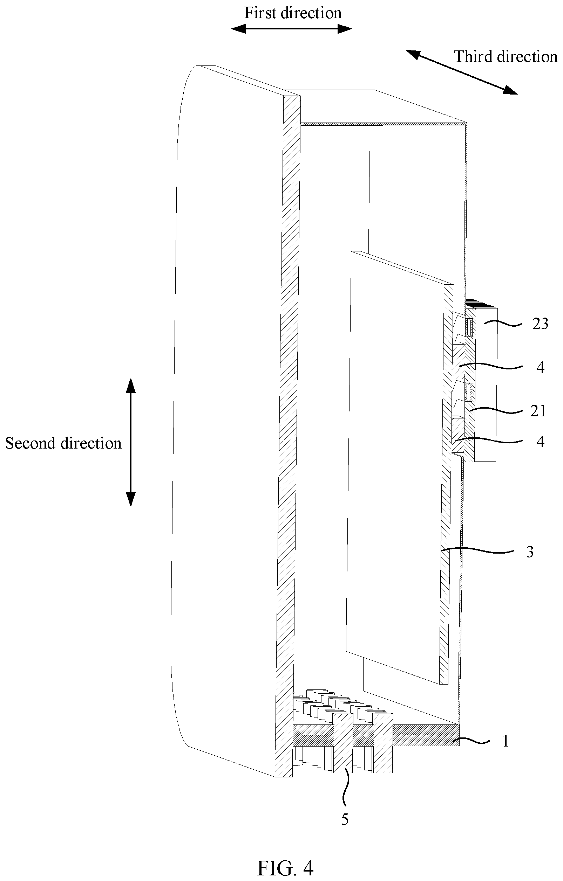

FIG. 3 shows an example of a structure of the heat sink 2. With reference to FIG. 3, the heat sink 2 includes a substrate 21 and a plurality of heat dissipation fins 23. The substrate 21 may be a thermally conductive plate made of aluminum, or may be a plate-shaped or disk-shaped structure made of another thermally conductive material. FIG. 4 is an example of a sectional view of the power converter 100, and is intended to reflect a mounting position of the heat sink 2. The substrate 21 includes two surfaces that are disposed opposite to each other in a first direction. One surface of the substrate 21 is attached to the power modules 4, and the plurality of heat dissipation fins 23 are disposed on the other surface of the substrate 21.

In the example shown in FIG. 4, the power modules 4 may be attached, through the opening 11, to the surface that is of the substrate 21 and that is away from the plurality of heat dissipation fins 23. It should be noted that, in some examples, to enable the substrate 21 and the power modules 4 to be better attached, a thermally conductive adhesive may be disposed between the substrate 21 and the power modules 4. In this case, the surface of the substrate 21 is also attached to the power modules 4.

The heat sink 2 further includes one or more heat pipes 22. In the example shown in FIG. 3, a plurality of heat pipes 22 are disposed. The plurality of heat pipes 22 are embedded in the surface that is of the substrate 21 and that is attached to the power modules 4. For example, the substrate 21 is provided with grooves 211, and the heat pipes 22 are disposed in the grooves 211. A thermal conductivity of the substrate 21 is less than a thermal conductivity of the heat pipe 22. For example, the substrate 21 is an aluminum plate, and the heat pipe 22 is a copper pipe. In addition, in some examples, a channel may be formed in the heat pipe 22, and the channel is filled with thermally conductive liquid (for example, a thermally conductive medium is added to water).

Refer to FIG. 3 and FIG. 4. When the power converter 100 runs, the power module 4 generates heat; and heat on the power module 4 is transferred to the substrate 21, and then is transferred from the substrate 21 to the heat dissipation fins 23 for heat exchange with air. In addition, the heat pipe 22 located on the substrate 21 has a stronger thermal conductive capability, and heat on the substrate 21 may be transferred to another location of the substrate 21 through the heat pipe 22. For example, the heat pipe 22 may transfer heat to an area that is of the substrate 21 and that is located on an outer periphery or an outer side of the power module 4, and heat is exchanged with air by using heat dissipation fins 23 of the substrate 21 in the area, so that more areas on the heat sink 2 are fully used, to implement efficient heat dissipation for the power module 4.

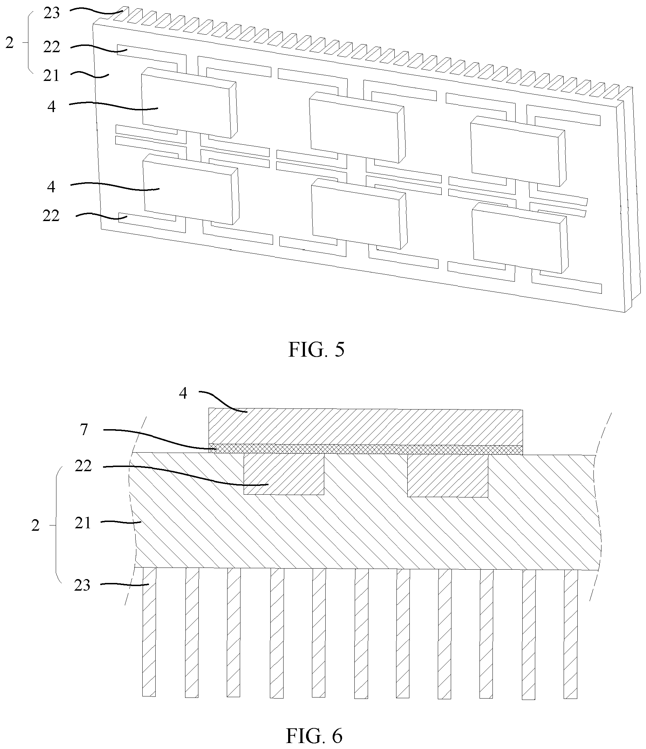

In the related technology, power modules 4 and heat pipes 22 are disposed in an overlapping manner. FIG. 5 shows an example of a structure of a heat sink 2 and power modules 4 in the related technology. Refer to FIG. 5. When the power modules 4 are mounted on a substrate 21, an orthographic projection of the power modules 4 on a surface of the substrate 21 coincides with an orthographic projection of the heat pipes 22 on the surface of the substrate 21. In other words, the power modules 4 and the heat pipes 22 overlap in a first direction, and the power modules 4 are in contact with the heat pipes 22. In this way, a part of heat generated by the power modules 4 is exchanged with air by using the substrate 21 and heat dissipation fins 23, the other part of heat is conducted to a colder part of the substrate 21 by using a high thermal conductivity of the heat pipes 22, and the other part of heat is finally exchanged by using the substrate 21 and heat dissipation fins 23 located in a colder area.

However, materials of the substrate 21 and the heat pipe 22 are usually different, and linear thermal expansion coefficients of the substrate 21 and the heat pipe 22 are also different. According to the solution of the foregoing related technology, when the power module 4 performs long-term heat dissipation, volumes of the substrate 21 and the heat pipe 22 change differently after the substrate 21 and the heat pipe 22 that are attached to the power module 4 expand and contract repeatedly. Consequently, contact between the heat pipe 22 and the power module 4 deteriorates, thermal conduction of a part that is of the power module 4 and that faces the heat pipe 22 deteriorates, heat dissipation of the heat sink 2 to the power module 4 deteriorates, and a risk that the power module 4 is damaged due to overtemperature exists, affecting reliability of the device.

FIG. 6 shows an example of another structure of a heat sink 2 and a power module 4 in the related technology (FIG. 6 is a sectional view). Refer to FIG. 6. When the power module 4 and a heat pipe 22 overlap, a thermally conductive pad 7 is disposed between the power module 4 and the substrate 21, and the heat pipe 22 and the power module 4 are separated through the thermally conductive pad 7. The thermally conductive pad 7 can absorb a volume change difference between the substrate 21 and the heat pipe 22 caused by different thermal expansion coefficients, to ensure that the power module 4 is always in contact with the substrate 21 and the heat pipe 22 reliably. However, in this way, in a process in which heat of the power module 4 is conducted to the substrate 21 and the heat pipe 22, an additional layer of material needs to be passed through. As a result, overall heat dissipation effect deteriorates, and finally, more heat dissipation means need to be used to reduce an operating temperature of the power module 4. This increases heat dissipation costs.

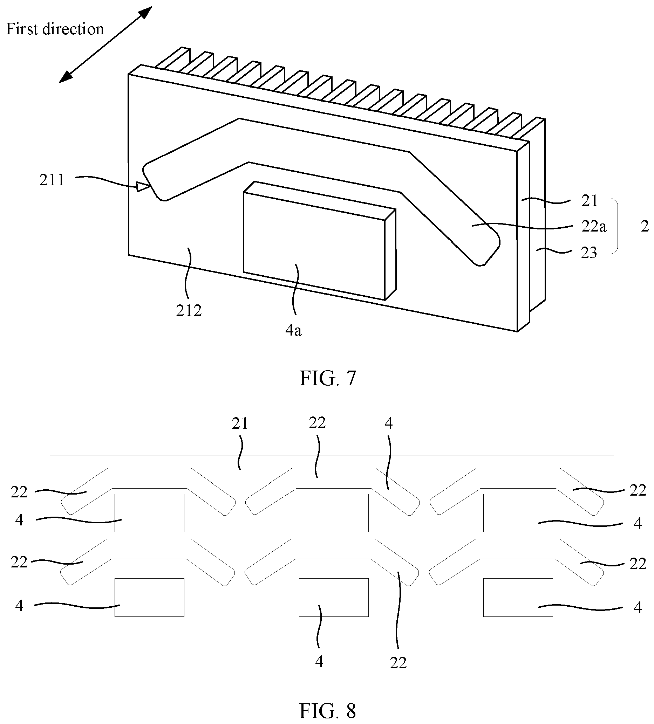

In an embodiment provided in this application, the heat pipe 22 is not in contact with the power module 4. FIG. 7 shows an example of a cooperation location between the power module 4 and the heat pipe 22, to reflect a cooperation relationship and a location relationship between one of the heat pipes 22 (for example, a first heat pipe 22a) and a corresponding power module 4 (for example, a first power module 4a). Refer to FIG. 7. The substrate 21 includes a surface 212 facing the power module 4 (the surface 212 is attached to the power module 4), and an orthographic projection of the first heat pipe 22a on a plane where the surface 212 is located on an outer side of an orthographic projection of the first power module 4a on the plane where the surface 212 is located. In other words, the first heat pipe 22a and the first power module 4a do not overlap in the first direction, and the first heat pipe 22a and the first power module 4a are not in contact with each other. This reduces impact of the heat pipe 22 and the substrate 21 on mounting of the power module 4 caused by different thermal expansion coefficients. It may be understood that the orthographic projections of the heat pipe 22 and the power module 4 on the surface 212 is orthographic projections of the heat pipe 22 and the power module 4 on the plane where the surface 212 is located.

In an example in which the substrate 21 is provided with the groove 211, the groove 211 is located on the outer periphery (or the outer side or outer circumference, including surrounding and not surrounding) of the power module 4. In this way, the heat pipe 22 (for example, the first heat pipe 22a) embedded in the groove 211 is also located on the outer periphery of the power module 4 (for example, the first power module 4a), so that the power module 4 and the heat pipe 22 do not overlap in the first direction. In other words, the power module 4 and the heat pipe 22 are distributed in a staggered manner in the first direction.

In an example in which a plurality of power modules 4 are disposed, for example, a quantity of power modules 4 may be the same as a quantity of heat pipes 22, each power module 4 corresponds to one heat pipe 22, and each power module 4 may cooperate with a corresponding heat pipe 22 in a manner shown in FIG. 7. FIG. 8 shows an example of the cooperation status between the heat sink 2 and the power modules 4.

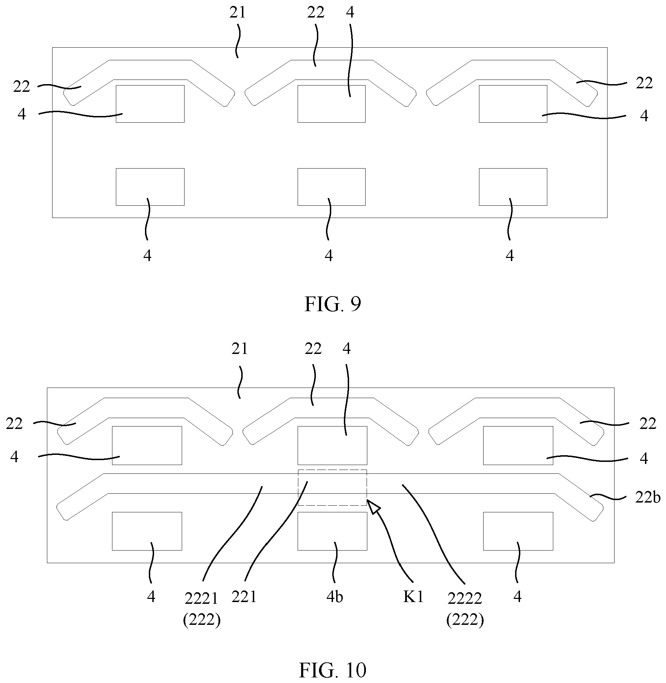

For another example, a quantity of power modules 4 is different from a quantity of heat pipes 22, at least one power module 4 corresponds to one heat pipe 22, and the power module 4 corresponding to the heat pipe 22 may cooperate with the corresponding heat pipe 22 in a manner shown in FIG. 7. FIG. 9 shows an example of the cooperation status between the heat sink 2 and the power modules 4.

For another example, a quantity of power modules 4 is different from a quantity of heat pipes 22, and a plurality of power modules 4 share one heat pipe 22 (for example, a second heat pipe 22b), that is, one heat pipe 22 (the second heat pipe 22b) can transfer heat of the plurality of power modules 4. FIG. 10 shows an example of the cooperation status of the heat sink 2 and the power modules 4. Three power modules 4 located in a lower row of the figure transfer heat through a same heat pipe 22 (the second heat pipe 22b). It may also be understood that when the second heat pipe 22b corresponds to one power module 4 (for example, a second power module 4b), the second heat pipe 22b can also dissipate heat for the remaining power modules 4 (for example, other power modules 4 on two sides of the second power module 4b).

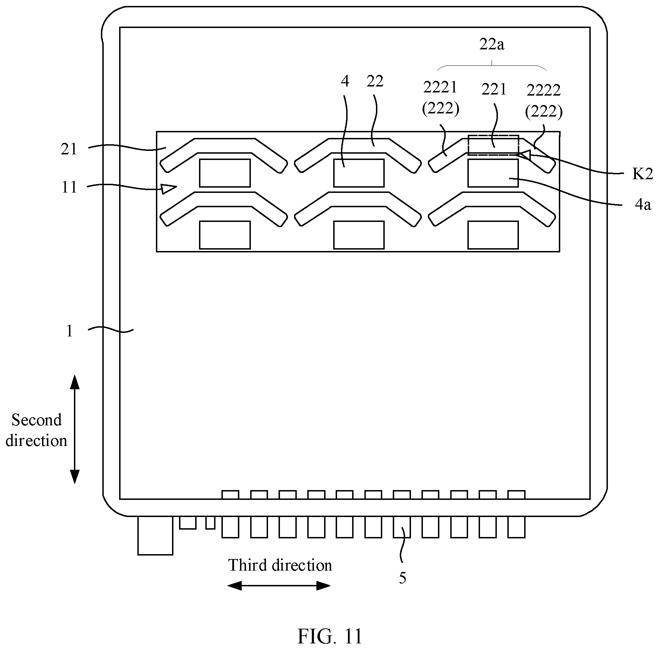

A location between the heat pipe 22 and the power module 4 may be designed in any proper form, and a location relationship between the heat pipe 22 and the power module 4 may also refer to another structure of the power converter 100, for example, may refer to a direct-current terminal 5. In some examples, to facilitate external connection, the power converter 100 further includes a plurality of direct-current terminals 5. FIG. 11 shows an example of a structure of the plurality of direct-current terminals 5. FIG. 11 shows an internal structure of the power converter 100, and the circuit board 3 is hidden, to expose the heat pipes 22 and the power modules 4 in the line of sight. The plurality of direct-current terminals 5 are configured to connect a connector of the photovoltaic module or the energy storage battery. The plurality of direct-current terminals 5 are fastened to the housing 1 and exposed from the housing 1. The direct-current terminals 5 and the power modules 4 are arranged in a second direction, and the second direction is perpendicular to the first direction.

For the location relationship between the heat pipe 22 and the power module 4, in some examples, with reference to FIG. 11, the heat pipe 22 includes a heated portion 221 and a heat transfer portion 222. The heated portion 221 does not exceed an edge of the power module 4 in a third direction, and the heat transfer portion 222 exceeds the edge of the power module 4 in the third direction. The third direction is perpendicular to the first direction and the second direction. The first heat pipe 22a and the first power module 4a are used as an example. In FIG. 11, a part of the heat pipe 22 in a dashed box K2 is a heated portion 221 of the first heat pipe 22a, and in FIG. 11, a part of the heat pipe 22 located outside the dashed box K2 is a heat transfer portion 222 of the first heat pipe 22a.

In the example shown in FIG. 11, in the second direction, the power module 4 is located between the heated portion 221 of the corresponding heat pipe 22 and the direct-current terminal 5 (using the first heat pipe 22a and the first power module 4a as an example). That is, a distance between a heated portion 221 of each heat pipe 22 and the direct-current terminal 5 is greater than a distance between the corresponding power module 4 and the direct-current terminal 5, and the heated portion 221 is located on one side that is of the power module 4 and that is away from the direct-current terminal 5.

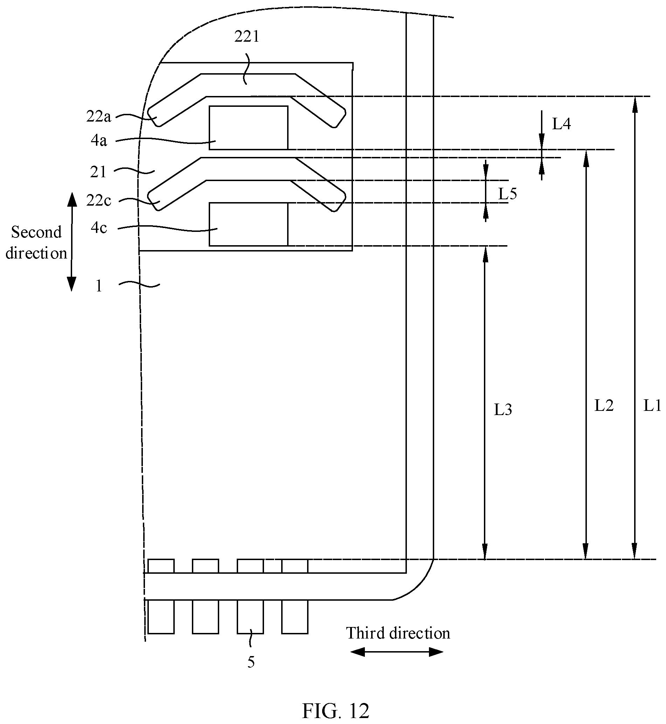

FIG. 12 shows an example of a distance between the heat pipe 22 and the direct-current terminal 5 and a distance between the power module 4 and the direct-current terminal 5 in the example in FIG. 11. FIG. 12 may be understood as a local view of FIG. 11, and the direct-current terminal 5 used as a distance reference may be any suitable direct-current terminal 5. The first heat pipe 22a and the first power module 4a are used as an example. A distance between the heated portion 221 of the first heat pipe 22a and the direct-current terminal 5 may be a minimum distance between an edge that is of the heated portion 221 of the first heat pipe 22a and that faces the direct-current terminal 5 and one end that is of the direct-current terminal 5 and that is close to the heated portion 221 of the first heat pipe 22a. For example, a distance L1 in FIG. 12 indicates the distance between the heated portion 221 of the first heat pipe 22a and the direct-current terminal 5. A distance between the first power module 4a and the direct-current terminal 5 may be a minimum distance between an edge that is of the first power module 4a and that faces the direct-current terminal 5 and one end that is of the direct-current terminal 5 and that is close to the first power module 4a. For example, a distance L2 in FIG. 12 indicates the distance between the first power module 4a and the direct-current terminal 5, and L1 is greater than L2.

The heat sink 2 in FIG. 11 and FIG. 12 may be the heat sink 2 in FIG. 8. In the examples shown in FIG. 11 and FIG. 12, for a location relationship between the remaining power modules 4 and the corresponding heat pipes 22 (the heated portion 221 does not exceed the edge of the corresponding power module 4 in the third direction, the heat transfer portion 222 exceeds the edge of the corresponding power module 4 in the third direction, and the distance between the heated portion 221 and the direct-current terminal 5 is greater than the distance between the corresponding power module 4 and the direct-current terminal 5), refer to a location relationship between the first heat pipe 22a and the first power module 4a in FIG. 12.

In addition, in the heat sink 2 in the examples in FIG. 9, FIG. 10, and the like, for the location relationship between the power module 4 and the corresponding heat pipe 22, refer to the location relationship between the first heat pipe 22a and the first power module 4a in FIG. 12. The heat sink 2 in FIG. 9 is similar to the heat sink 2 in FIG. 8, and only a quantity of heat pipes 22 is different. Therefore, details are not described again. When the heat sink 2 in FIG. 10 is used in the housing 1 shown in FIG. 11 and FIG. 12 (not shown in the figure), the second heat pipe 22b and the second power module 4b are used as an example. The second power module 4b is any one of the plurality of power modules 4 that share the second heat pipe 22b, and the second heat pipe 22b includes a heated portion 221 and a heat transfer portion 222. In FIG. 10, a part of the second heat pipe 22b in a dashed box K1 is the heated portion 221 of the second heat pipe 22b, and in FIG. 10, a part of the second heat pipe 22b outside the dashed box K1 is the heat transfer portion 222 of the second heat pipe 22b. The heated portion 221 of the second heat pipe 22b does not exceed an edge of the second power module 4b in the third direction, and the heat transfer portion 222 of the second heat pipe 22b exceeds the edge of the second power module 4b in the third direction. In the second direction, a distance between the heated portion 221 of the second heat pipe 22b and the direct-current terminal 5 is greater than a distance between the second power module 4b and the direct-current terminal 5, that is, the heated portion 221 of the second heat pipe 22b is located on one side that is of the second power module 4b and that is away from the direct-current terminal 5.

After the power converter 100 is mounted, the direct-current terminal 5 may be located at the bottom of the housing 1, to facilitate on-site mounting and wiring and facilitate better connection between an external line and the direct-current terminal 5. In addition, the direct-current terminal 5 is disposed at the bottom of the housing 1 to also implement a waterproof function. During natural heat dissipation, hot air rises, and heat of the power module 4 is concentrated in an area above the power module 4. The heated portion 221 of the heat pipe 22 corresponding to the power module 4 is disposed in this area. That is, a large amount of heat of the power module 4 is gathered to the heated portion 221, and then is transferred from the heated portion 221 to the heat transfer portion 222. Because a heat transfer portion 222 of each heat pipe 22 protrudes from an edge of the corresponding power module 4, heat on the heat transfer portion 222 may be transferred to an area around the power module 4, so that more areas on the heat sink 2 are used, and heat dissipation effect is better.

In some examples, the heat transfer portion 222 of the heat pipe 22 bends toward the power module 4. For example, refer to FIG. 11 and FIG. 12. The heat transfer portion 222 of the first heat pipe 22a bends toward one side where the first power module 4a is located. Because the heat transfer portion 222 exceeds an edge of the heat pipe 22 and bends toward the power module 4, heat on the heat pipe 22 is conducted to a side of the corresponding power module 4, that is, the heat is guided to a colder area of the substrate 21. The area that is of the heat sink 2 and that is located on the side of the power module 4 is fully used, so that more areas on the heat sink 2 can be used for heat dissipation, and utilization and heat dissipation effect of the heat sink 2 are improved.

In addition, in some examples, the heat transfer portion 222 of the heat pipe 22 may include a first part 2221 and a second part 2222. An arrangement direction of the first part 2221 and the second part 2222 is perpendicular to an arrangement direction of the heated portion 221 and the corresponding power module 4. The first part 2221 and the second part 2222 respectively exceed the edges of two sides of the power module 4 in the arrangement direction of the first part 2221 and the second part 2222. In the example shown in FIG. 11, the first power module 4a and the first heat pipe 22a are used as an example. A first part 2221 and a second part 2222 of the first heat pipe 22a respectively exceed different sides of the first power module 4a in the third direction, and both the first part 2221 and the second part 2222 of the first heat pipe 22a bend toward the first power module 4a.

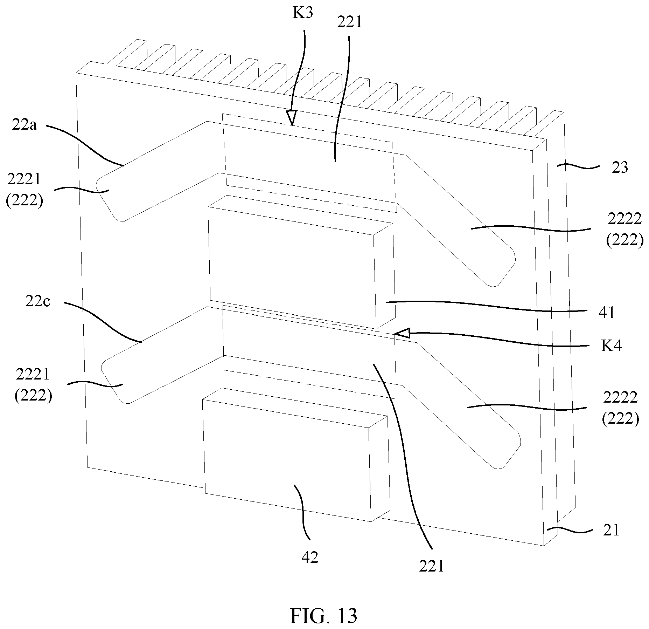

In some examples, a plurality of power modules 4 are disposed, and the plurality of power modules 4 include an inverter module 41 (one type of the power module 4) and a direct-current voltage conversion module 42 (one type of the power module 4). FIG. 13 shows an example of a structure of the inverter module 41 and the direct-current voltage conversion module 42. It may be understood that FIG. 13 shows only a part of the power converter 100. The direct-current voltage conversion module 42 is configured to perform voltage conversion on a direct current of the photovoltaic module or the energy storage battery, and the inverter module 41 is configured to convert a direct current output by the direct-current voltage conversion module 42 into an alternating current. In addition, a plurality of heat pipes 22 are also disposed, and one of the plurality of heat pipes 22, for example, the first heat pipe 22a, corresponds to the inverter module 41; and another heat pipe 22 of the plurality of heat pipes 22, for example, a third heat pipe 22c, corresponds to the direct-current voltage conversion module 42.

The inverter module 41 and the direct-current voltage conversion module 42 in FIG. 13 are used in the examples in FIG. 11 and FIG. 12, that is, two power modules 4 arranged in the second direction in FIG. 12 may be considered as the inverter module 41 and the direct-current voltage conversion module 42. For example, the first power module 4a in FIG. 12 may be the inverter module 41, and a third power module 4c in FIG. 12 may be the direct-current voltage conversion module 42. The inverter module 41, the third heat pipe 22c, and the direct-current voltage conversion module 42 are sequentially arranged in the second direction, that is, the third heat pipe 22c is located between the inverter module 41 and the direct-current voltage conversion module 42 in the second direction.

Refer to FIG. 12 and FIG. 13. In the second direction, a distance between the inverter module 41 (the first power module 4a) and the direct-current terminal 5 is greater than a distance between the direct-current voltage conversion module 42 (the third power module 4c) and the direct-current terminal 5, that is, the direct-current voltage conversion module 42 is located between the inverter module 41 and the direct-current terminal 5 in the second direction. The distance between the inverter module 41 (the first power module 4a) and the direct-current terminal 5 may be a minimum distance between an edge that is of the inverter module 41 and that faces the direct-current terminal 5 and one end that is of the direct-current terminal 5 and that is close to the inverter module 41. For example, the distance L2 in FIG. 12 indicates the distance between the inverter module 41 (the first power module 4a) and the direct-current terminal 5. The distance between the direct-current voltage conversion module 42 (the third power module 4c) and the direct-current terminal 5 may be a minimum distance between an edge that is of the direct-current voltage conversion module 42 and that faces the direct-current terminal 5 and one end that is of the direct-current terminal 5 and that is close to the direct-current voltage conversion module 42. For example, a distance L3 in FIG. 12 indicates the distance between the direct-current voltage conversion module 42 (the third power module 4c) and the direct-current terminal 5, and L2 is greater than L3. It may be understood that the inverter module 41 may be disposed on one side that is of the direct-current voltage conversion module 42 and that is away from the direct-current terminal 5. In another example (not shown in the figure), the direct-current voltage conversion module 42 may be disposed on one side that is of the inverter module 41 that is away from the direct-current terminal 5.

Refer to FIG. 12 and FIG. 13. In the second direction, a distance between the inverter module 41 (the first power module 4a) and the heat pipe 22 (the third heat pipe 22c) that is located between the inverter module 41 and the direct-current voltage conversion module 42 is less than a distance between the direct-current voltage conversion module 42 (the third power module 4c) and the heat pipe 22 (the third heat pipe 22c) that is located between the inverter module 41 and the direct-current voltage conversion module 42.

The distance between the inverter module 41 and the third heat pipe 22c in the second direction may be a minimum distance between an edge that is of the inverter module 41 (the first power module 4a) and that faces the third heat pipe 22c and an edge that is of the third heat pipe 22c and that faces the inverter module 41. For example, a distance L4 in FIG. 12 indicates the distance between the inverter module 41 (the first power module 4a) and the third heat pipe 22c in the second direction. The distance between the direct-current voltage conversion module 42 (the third power module 4c) and the third heat pipe 22c in the second direction may be a minimum distance between an edge that is of the direct-current voltage conversion module 42 and that faces the third heat pipe 22c and an edge that is of the third heat pipe 22c and that faces the direct-current voltage conversion module 42. For example, a distance L5 in FIG. 12 indicates the distance between the direct-current voltage conversion module 42 (the third power module 4c) and the third heat pipe 22c in the second direction, and it is not difficult to learn that L5 is greater than L4.

In addition, refer to FIG. 11 to FIG. 13. The inverter module 41 and the direct-current voltage conversion module 42 in FIG. 13 are used in the examples in FIG. 11 and FIG. 12. The heat pipe 22 (for example, the first heat pipe 22a) corresponding to the inverter module 41 includes the heated portion 221 and the heat transfer portion 222. The heated portion 221 of the first heat pipe 22a does not exceed an edge of the inverter module 41 in the third direction, and the heat transfer portion 222 of the first heat pipe 22a exceeds the edge of the inverter module 41 in the third direction. In FIG. 13, a part that is of the first heat pipe 22a and that is located in a dashed box K3 is the heated portion 221 of the first heat pipe 22a, and in FIG. 13, a part that is of the heat pipe 22a and that is located outside the dashed box K3 is the heat transfer portion 222 of the first heat pipe 22a. Similarly, the heat pipe 22 (for example, the third heat pipe 22c) corresponding to the direct-current voltage conversion module 42 also includes a heated portion 221 and a heat transfer portion 222. The heated portion 221 of the third heat pipe 22c does not exceed an edge of the direct-current voltage conversion module 42 in the third direction, and the heat transfer portion 222 of the third heat pipe 22c exceeds the edge of the direct-current voltage conversion module 42 in the third direction. In FIG. 13, a part that is of the third heat pipe 22c and that is located in a dashed box K4 is the heated portion 221 of the third heat pipe 22c, and in FIG. 13, a part that is of the third heat pipe 22c and that is located outside the dashed box K4 is the heat transfer portion 222 of the third heat pipe 22c.

When heat of the direct-current voltage conversion module 42 is transferred in the second direction, heat can be transferred to the heated portion 221 of the third heat pipe 22c. Because the third heat pipe 22c between the inverter module 41 and the direct-current voltage conversion module 42 is closer to the inverter module 41, a part of heat of the inverter module 41 is also transferred to the heated portion 221 of the third heat pipe 22c. The third heat pipe 22c may also assist the inverter module 41 in heat dissipation while assisting the direct-current voltage conversion module 42 in heat dissipation. This facilitates heat dissipation of the inverter module 41 that generates more severe heat (for example, in some cases, when the power converter 100 runs, heat of the inverter module 41 is greater than heat of the direct-current voltage conversion module 42).

In an example in which the heat pipe 22 is disposed between the inverter module 41 and the direct-current voltage conversion module 42, the heat transfer portion 222 of the heat pipe 22 located between the inverter module 41 and the direct-current voltage conversion module 42 bends toward the direct-current voltage conversion module 42. The third heat pipe 22c in FIG. 13 is used as an example, the heat transfer portion 222 of the third heat pipe 22c bends toward one side of the direct-current voltage conversion module 42. In addition, in some examples, the heat transfer portion 222 of the third heat pipe 22c may include a first part 2221 and a second part 2222. An arrangement direction of the first part 2221 and the second part 2222 is perpendicular to an arrangement direction of the heated portion 221 of the third heat pipe 22c and the direct-current voltage conversion module 42. The first part 2221 and the second part 2222 respectively exceed edges of two sides of the direct-current voltage conversion module 42 in the arrangement direction of the first part 2221 and the second part 2222, and both the first part 2221 and the second part 2222 of the third heat pipe 22c bend toward the direct-current voltage conversion module 42.

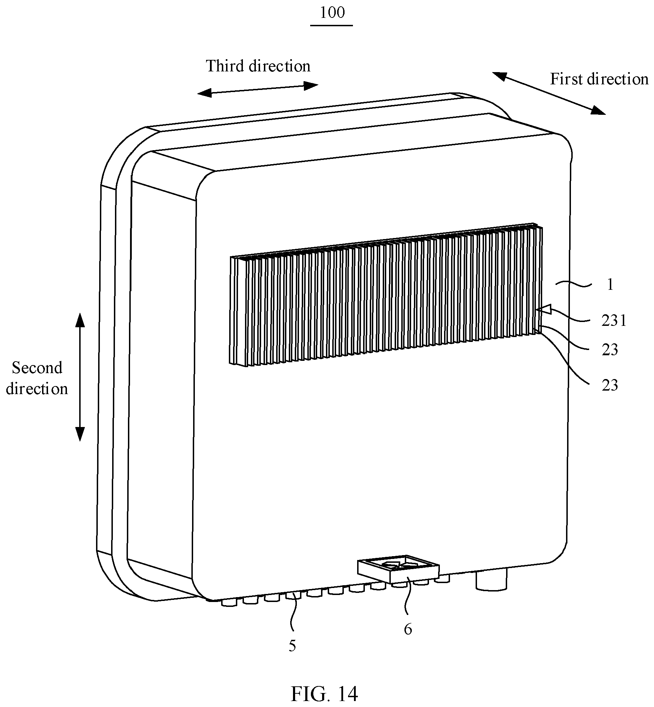

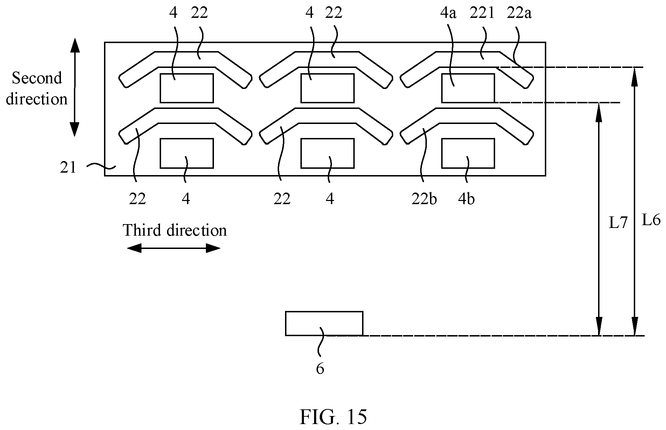

In some examples, the power converter 100 further includes a fan 6. FIG. 14 shows an example of a structure of the fan 6. The fan 6 is configured to blow air toward the heat sink 2, to improve a heat dissipation capability. FIG. 15 shows an example of a distance between the heat pipe 22 and the fan 6 and a distance between the power module 4 and the fan 6 in the example shown in FIG. 14. The fan 6 and the power module 4 are arranged in the second direction. The power module 4 is located between an air outlet of the fan 6 and the heated portion 221 in the second direction. That is, a distance between the air outlet of the fan 6 and the power module 4 is less than a distance between the air outlet of the fan 6 and the heated portion 221 of the heat pipe 22. The air outlet of the fan 6 may be one end that is of the fan 6 and that faces the power module 4. The first heat pipe 22a and the first power module 4a are used as an example, a distance L6 in FIG. 15 indicates the distance between the air outlet of the fan 6 and the heated portion 221 of the first heat pipe 22a in the second direction, and a distance L7 in FIG. 15 indicates the distance between the air outlet of the fan 6 and the first power module 4a in the second direction.

That is, after the power converter 100 is mounted, the direct-current terminals 5 may be located at the bottom of the housing 1, and the fan 6 may be located below the power module 4. In a running process of the power converter 100, the fan 6 may blow air toward the power module 4, so that most heat on the power module 4 is concentrated on one side that is of the power module 4 and that is away from the fan 6, and the heated portion 221 is disposed in this area. Under an action of the fan 6, a large amount of heat of the power module 4 is blown to the heated portion 221, and then is transferred from the heated portion 221 to the heat transfer portion 222. The heat on the heat transfer portion 222 may be transferred to a side area of the power module 4, so that more areas on the heat sink 2 are used, and heat dissipation effect is better. Fan heat dissipation and natural heat dissipation are combined. A large amount of heat of the power module 4 is gathered to the heated portion 221, and fan heat dissipation assists natural heat dissipation. This helps improve heat dissipation effect of the power module 4.

The examples shown in FIG. 14 and FIG. 15 may be understood as adding the fan 6 in the examples shown in FIG. 11 and FIG. 12. In an example in which the fan 6 is disposed, an arrangement direction of the plurality of heat dissipation fins 23 may be perpendicular to an arrangement direction of the fan 6 and the power module 4. An air duct 231 is formed between two adjacent heat dissipation fins 23. The air duct 231 extends in the arrangement direction of the fan 6 and the power module 4. The air outlet of the fan 6 faces one end that is of at least one air duct 231 and that is close to the fan 6.

For example, in the examples shown in FIG. 14 and FIG. 15, the air duct 231 extends in the second direction. When the fan 6 blows air toward the heat dissipation fins 23, air flows through the heat dissipation fins 23 through the air duct 231, so that air blown out from the fan 6 flows in the arrangement direction of the fan 6 and the power module 4. Because the heated portion 221 is located on one side that is of the power module 4 and that is away from the fan 6, heat is also transferred to the heated portion 221 along with a flow direction of the air. This facilitates heat concentration and transfer of the heated portion 221. In addition, an extension direction of the air duct 231 is the same as an air direction. This also helps air flow in the air duct 231, reduces a possibility that the heat dissipation fins 23 obstruct the air flow, and enables the fan to dissipate heat normally.

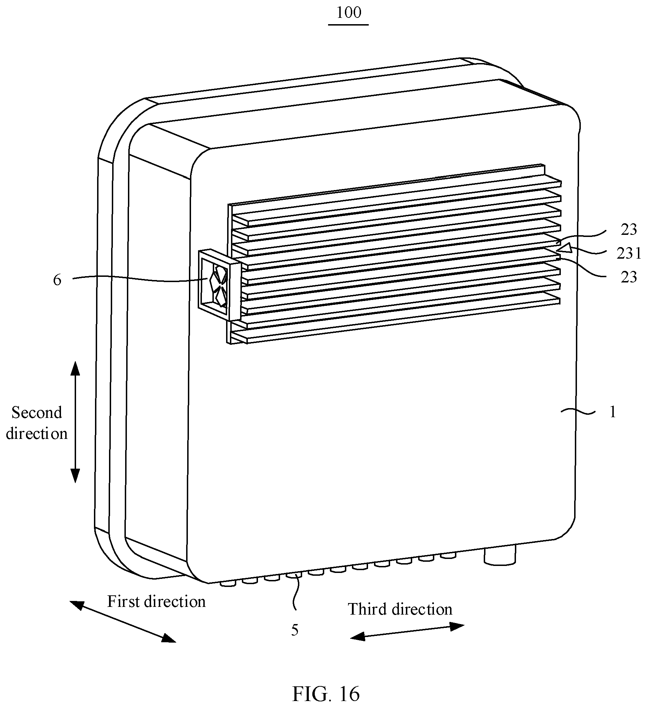

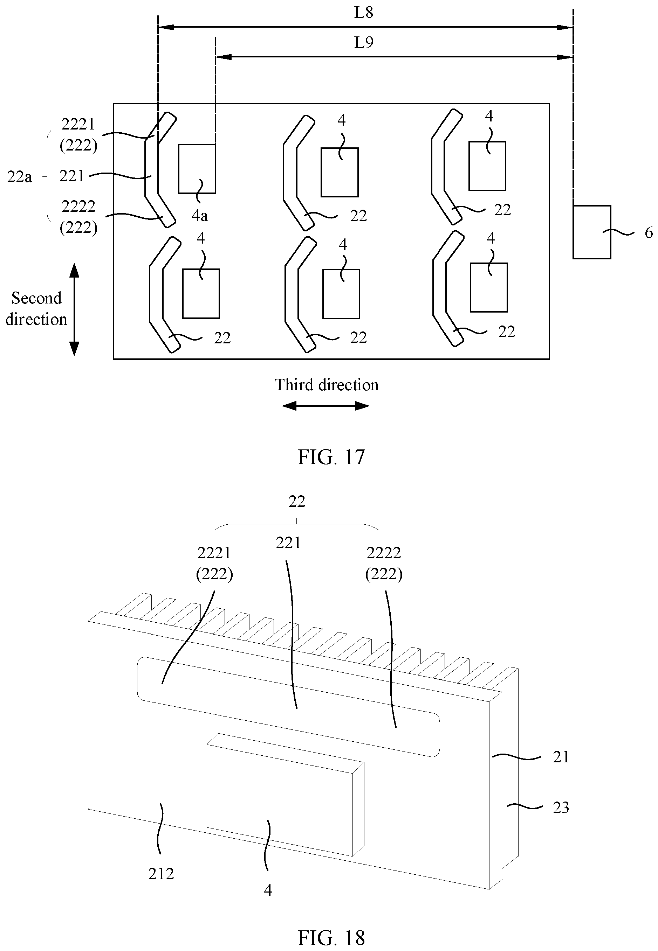

For the location relationship between the heat pipe 22 and the power module 4, in some other examples, the fan 6 may also be used as a reference. FIG. 16 shows an example of another structure of the fan 6. The fan 6 blows air toward the heat sink 2. FIG. 17 shows an example of a distance between the heat pipe 22 and the fan 6 and a distance between the power module 4 and the fan 6 in the example in FIG. 16. Refer to FIG. 16 and FIG. 17. The fan 6 and the power module 4 are arranged in the third direction. The third direction is perpendicular to the first direction. The power converter 100 further includes the plurality of direct-current terminals 5. The direct-current terminals 5 are configured to connect to the photovoltaic module or the energy storage battery. The direct-current terminals 5 are fastened to the housing 1 and are exposed from the housing 1. The direct-current terminals 5 and the power module 4 are arranged in the second direction. The second direction is perpendicular to the first direction and the third direction.

Refer to FIG. 17. The heat pipe 22 includes the heated portion 221 and the heat transfer portion 222. The first heat pipe 22a is used as an example. The heated portion 221 of the first heat pipe 22a does not exceed an edge of the power module 4 in the second direction, and the heat transfer portion 222 of the first heat pipe 22a exceeds the edge of the power module 4 still in the second direction.

In the examples shown in FIG. 16 and FIG. 17, the power module 4 is located between the air outlet of the fan 6 and the heated portion 221 in the third direction, that is, a distance between the air outlet of the fan 6 and the power module 4 is less than a distance between the air outlet of the fan 6 and the heated portion 221 of the heat pipe 22. The first heat pipe 22a and the first power module 4a are used as an example, a distance L8 in FIG. 17 indicates the distance between the air outlet of the fan 6 and the heated portion 221 of the first heat pipe 22a in the third direction, a distance L9 in FIG. 17 indicates the distance between the air outlet of the fan 6 and the first power module 4a in the third direction, and L8 is greater than L9.

Refer to FIG. 16 and FIG. 17. The arrangement direction of the plurality of heat dissipation fins 23 is perpendicular to the arrangement direction of the fan 6 and the power module 4. The air duct 231 formed between two adjacent heat dissipation fins 23 extends in the arrangement direction of the fan 6 and the power module 4, that is, the air duct 231 extends in the third direction. When the fan 6 blows air toward the heat dissipation fins 23, air flows through the heat dissipation fins 23 through the air duct 231. This reduces a possibility that the heat dissipation fins 23 obstruct air flow, and enables the fan 6 to assist in heat dissipation normally.

In the examples shown in FIG. 16 and FIG. 17, the first power module 4a may be the inverter module 41, and the third power module 4c may be the direct-current voltage conversion module 42.

In the examples shown in FIG. 16 and FIG. 17, the heat transfer portion 222 of the first heat pipe 22a bends toward one side of the first power module 4a. In addition, the first part 2221 and the second part 2222 of the first heat pipe 22a respectively exceed different sides of the first power module 4a in the second direction, and both the first part 2221 and the second part 2222 of the first heat pipe 22a bend toward the first power module 4a.

The heat pipe 22 in this application may be formed by bending a straight pipe. In some other examples, the heat pipe 22 may also be a straight pipe, and does not bend toward one side of the power module 4. For example,

FIG. 18 is a diagram of an example of another location between the power module 4 and the heat pipe 22. In the example shown in FIG. 18, both ends of the heat pipe 22 exceed the edge of the power module 4, but the heat pipe 22 does not bend toward the power module 4.

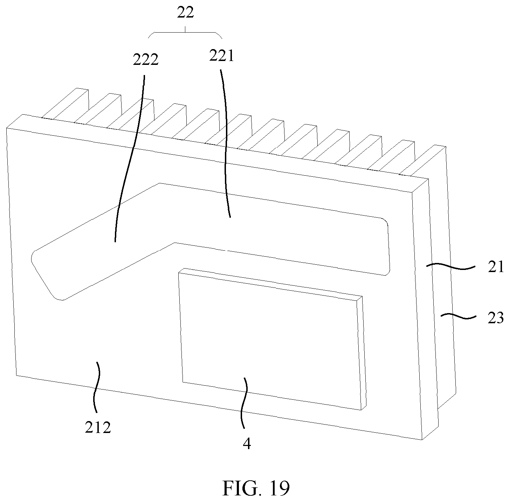

In some other examples, one end of the heat pipe 22 bends toward the power module 4. For example, FIG. 19 is a diagram of still another location between the power module 4 and the heat pipe 22. In the example shown in FIG. 19, the heat transfer portion 222 of the heat pipe 22 is not distinguished as the first part 2221 and the second part 2222. That is, the heat transfer portion 222 is located at one end of the heated portion 221, and the heat transfer portion 222 of the heat pipe 22 bends toward the power module 4.

In addition, the heated portion 221 and the heat transfer portion 222 in this application are used to divide different parts of the heat pipe 22 only by using a name difference. Specifically, locations of the heated portion 221 and the heat transfer portion 222 need to be determined with reference to a limitation in this application, and "high temperature" and "low temperature" cannot be considered as limitations on a temperature of a structure of this application.

In another example, the power converter 100 includes only one power module 4, and a corresponding heat pipe 22 is disposed on a side of the power module 4. In another example, the power converter 100 includes a plurality of power modules 4, but the heat sink 2 includes only one heat pipe 22. The heat pipe 22 is not in contact with any power module 4, and an orthographic projection of the heat pipe 22 on a surface 212 is located on an outer side of an orthographic projection of each power module 4 on the surface 212. A quantity of power modules 4 and a quantity of heat pipes 22 are not limited in this application, provided that one power module 4 and one heat pipe 22 meet a condition limited in this application.

In another example, the heat pipe 22 may be of a serpentine shape or a special shape, and a shape of the heat pipe 22 is not limited to a shape shown in the accompanying drawings of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, wherein the power converter is configured to convert a direct current from a photovoltaic module or an energy storage battery into an alternating current, and the power converter comprises a housing, one or more power modules, and a heat sink, wherein
the housing is configured to accommodate the power module; and
the heat sink comprises a substrate, one or more heat pipes, and a plurality of heat dissipation fins, wherein one surface of the substrate is attached to the power module, the heat pipe is further embedded in the surface of the substrate, the plurality of heat dissipation fins are disposed on the other surface of the substrate, the surface of the substrate is disposed opposite to the other surface of the substrate in a first direction, an orthographic projection of the heat pipe on the surface that is of the substrate and that is attached to the power module is located on an outer side of an orthographic projection of the power module on the surface, and a thermal conductivity of the substrate is less than a thermal conductivity of the heat pipe.

2. The power converter according to claim 1, wherein the power converter further comprises a plurality of direct-current terminals, the plurality of direct-current terminals are configured to connect to the photovoltaic module or the energy storage battery, the plurality of direct-current terminals are fastened and partially exposed from the housing, the direct-current terminals and the power module are arranged in a second direction, and the second direction is perpendicular to the first direction;
the heat pipe comprises a heated portion and a heat transfer portion, the heated portion does not exceed an edge of the power module in a third direction, the heat transfer portion exceeds the edge of the power module in the third direction, and the third direction is perpendicular to the first direction and the second direction; and
the power module is located between the heated portion and the direct-current terminals in the second direction.

3. The power converter according to claim 2, wherein the power converter further comprises a fan, the fan and the power module are arranged in the second direction, and the power module is located between an air outlet of the fan and the heated portion in the second direction.

4. The power converter according to claim 1, wherein the power converter further comprises a fan, the fan and the power module are arranged in a third direction, and the third direction is perpendicular to the first direction;
the power converter further comprises a plurality of direct-current terminals, the plurality of direct-current terminals are configured to connect to the photovoltaic module or the energy storage battery, the direct-current terminals are fastened to the housing and exposed from the housing, the direct-current terminals and the power module are arranged in a second direction, and the second direction is perpendicular to the first direction and the third direction;
the heat pipe comprises a heated portion and a heat transfer portion, the heated portion does not exceed an edge of the power module in the second direction, and the heat transfer portion exceeds the edge of the power module in the second direction; and
the power module is located between an air outlet of the fan and the heated portion in the third direction.

5. The power converter according to claim 3 or 4, wherein an arrangement direction of the plurality of heat dissipation fins is perpendicular to an arrangement direction of the fan and the power module, an air duct is formed between two adjacent heat dissipation fins, the air duct extends in the arrangement direction of the fan and the power module, and the air outlet of the fan faces one end that is of at least one air duct and that is close to the fan.

6. The power converter according to any one of claims 2 to 5, wherein the heat transfer portion of the heat pipe bends toward the power module.

7. The power converter according to any one of claims 2 to 6, wherein the heat transfer portion comprises a first part and a second part, an arrangement direction of the first part and the second part is perpendicular to an arrangement direction of the heated portion and the power module, and the first part and the second part respectively exceed edges of different sides of the power module in the arrangement direction of the first part and the second part.

8. The power converter according to claim 2 or 3, wherein a plurality of power modules are disposed, the plurality of power modules comprise a direct-current voltage conversion module and an inverter module, the direct-current voltage conversion module is configured to perform voltage conversion on a direct current of the photovoltaic module or the energy storage battery, the inverter module is configured to convert a direct current output by the direct-current voltage conversion module into an alternating current, the inverter module, the heat pipe, and the direct-current voltage conversion module are sequentially arranged in the second direction, the direct-current voltage conversion module is located between the inverter module and the direct-current terminals in the second direction, and in the second direction, a distance between the inverter module and the heat pipe that is located between the inverter module and the direct-current voltage conversion module is less than a distance between the direct-current voltage conversion module and the heat pipe that is located between the inverter module and the direct-current voltage conversion module.

9. The power converter according to claim 8, wherein the heat transfer portion of the heat pipe located between the inverter module and the direct-current voltage conversion module bends toward the direct-current voltage conversion module.

10. The power converter according to any one of claims 1 to 9, wherein a groove is provided on the surface that is of the substrate and that is attached to the power module, the groove is located on an outer periphery of the power module, and the heat pipe is disposed in the groove.
